(19) Europäisches Patentamt
European Patent Office
Office européen des brevets

(11) **EP 3 678 307 A1**

(12) **EUROPEAN PATENT APPLICATION**

(43) Date of publication:
**08.07.2020 Bulletin 2020/28**

(51) Int Cl.:
**H04B 10/58** (2013.01)  **H01S 5/00** (2006.01)

(21) Application number: **19305006.9**

(22) Date of filing: **03.01.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Nokia Solutions and Networks Oy 02610 Espoo (FI)**

(72) Inventor: **DEBREGEAS, Hélène 78150 Paris (FR)**

(74) Representative: **Bryers LLP 7 Gay Street Bath, Bath and North East Somerset BA1 2PH (GB)**

(54) **LASER APPARATUS**

(57) A laser apparatus comprises a periodically structured active region, a phase shift region adjacent to the periodically structured active region, a coating adjacent to the periodically structured active region, a first driver to inject a current into the periodically structured active region to generate an amplitude modulated optical output, and a second driver to inject a counter-modulating current into the phase shift region to shift a wavelength of emission of the laser apparatus.

FIG. 3

## Description

TECHNICAL FIELD

Aspects relate, in general, to a laser apparatus, a method and a transmitter.

BACKGROUND

Directly modulated Lasers (DMLs), based on Distributed Feedback Lasers (DFBs) are widely used transmitters owing to their simple fabrication, simple control, and high output power. Output light amplitude is directly modulated by changing the laser current between a value close to threshold for 0-bits, and a value with high power for the 1-bits.

SUMMARY

According to an example, there is provided a laser apparatus comprising a periodically structured active region, a phase shift region adjacent to the periodically structured active region, a coating adjacent to the periodically structured active region, a first driver to inject a current into the periodically structured active region to generate an amplitude modulated optical output, and a second driver to inject a counter-modulating current into the phase shift region to shift a wavelength of emission of the laser apparatus. The periodically structured active region can be a diffraction grating. The coating can be an anti-reflective coating. A highly reflective coating can be provided adjacent the phase shift region. A second periodically structured active region adjacent to the phase shift region, and a second coating adjacent to the second periodically structured active region can be provided. The second coating can be an anti-reflective coating.

According to an example, there is provided a method for supressing adiabatic chirp in the emission wavelength of a laser apparatus, the method comprising injecting a modulated current into a periodically structured active region of the laser apparatus to drive generation of an amplitude modulated optical output, and injecting a counter-modulating current into a phase shift region of the laser apparatus to shift the wavelength of emission of the optical output. The method can further comprise determining a level of adiabatic chirp as a result of a shift in laser apparatus stop-band due to a refractive index change stemming from generation of the amplitude modulated optical output, and selecting the counter-modulating current to supress the said adiabatic chirp by shifting the wavelength of emission of the optical output inside the stop-band. The adiabatic chirp can result from a transition of an optical output from or to a 0-bit. The method can further comprise injecting a counter-modulating current into a phase shift region of the laser apparatus to shift the wavelength of emission of the optical output towards the lower limit of the laser apparatus stop-band.

The counter-modulating current can be selected to reduce the wavelength of emission of the optical output. The counter-modulating current can be between 2-20mA.

According to an example, there is provided a transmitter for use in a wireless telecommunications network, the transmitter comprising a laser structure, and a controller to select a first current for injection into a periodically structured active region of the laser structure to generate an amplitude modulated optical output of the transmitter, and select a counter-modulating current for injection into a phase shift region of the laser structure to shift a wavelength of emission of the transmitter to stabilise the wavelength amplitude modulated optical output. The laser structure can comprise a coating adjacent to the periodically structured active region. The transmitter can further comprise a first driver to supply the first current into the periodically structured active region of the laser structure, and a second driver to supply the counter-modulating current into the phase shift region of the laser structure.

BRIEF DESCRIPTION OF THE DRAWINGS

Embodiments will now be described, by way of example only, with reference to the accompanying drawings, in which:

Figure 1 is a schematic representation of amplitude and frequency variation during a "010" modulation at 1Gb/s for a DML showing typical 6GHz adiabatic chirp;

Figure 2 is a schematic representation of amplitude and frequency variation during a "010" modulation at 1Gb/s for an EML (no adiabatic chirp);

Figure 3 is a schematic representation of a laser apparatus according to an example;

Figure 4 is a schematic representation of a laser spectrum when varying $I_{phase}$ according to an example;

Figures 5a and 5b are schematic representations of a DFB spectrum for 0 and 1 bits according to an example;

Figure 6 is a schematic representation of a laser apparatus according to an example; and

Figure 7 is a schematic representation of a transmitter according to an example.

DESCRIPTION

Example embodiments are described below in sufficient detail to enable those of ordinary skill in the art to embody and implement the systems and processes herein described. It is important to understand that embodiments can be provided in many alternate forms and should not be construed as limited to the examples set forth herein.

Accordingly, while embodiments can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

The terminology used herein to describe embodiments is not intended to limit the scope. The articles "a," "an," and "the" are singular in that they have a single referent, however the use of the singular form in the present document should not preclude the presence of more than one referent. In other words, elements referred to in the singular can number one or more, unless the context clearly indicates otherwise. It will be further understood that the terms "comprises," "comprising," "includes," and/or "including," when used herein, specify the presence of stated features, items, steps, operations, elements, and/or components, but do not preclude the presence or addition of one or more other features, items, steps, operations, elements, components, and/or groups thereof.

Unless otherwise defined, all terms (including technical and scientific terms) used herein are to be interpreted as is customary in the art. It will be further understood that terms in common usage should also be interpreted as is customary in the relevant art and not in an idealized or overly formal sense unless expressly so defined herein.

DMLs suffer from adiabatic chirp which limits transmission distance / bit rate. Output light amplitude is directly modulated by changing the laser current between a value close to threshold ($I_0$) for 0-bits, and a value with high power ($I_1$, typically 100mA for example) for the 1-bits. Changing the current generates a variation of carrier density in the laser cavity due to gain compression, leading to a variation of effective refractive index, $n_{eff}$. As the emitted wavelength of a DFB is given by $\lambda = 2.n_{eff}.L$, with L being the grating pitch, the variation of $n_{eff}$ generates a variation of $\lambda$.

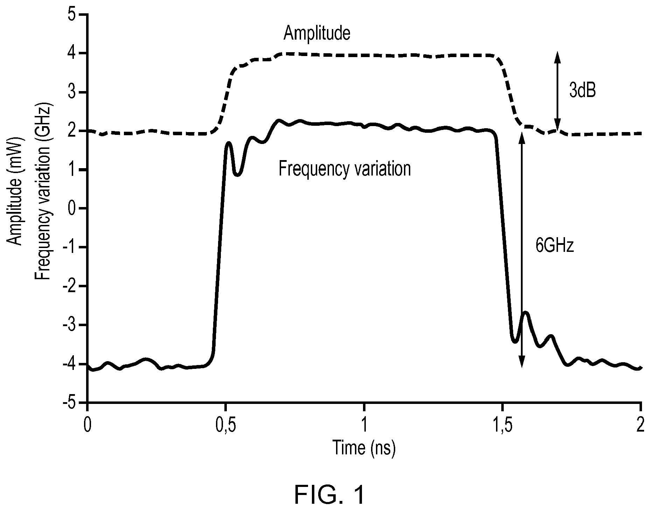

Carrier density increases during generation of a 1-bit, leading to a lower $n_{eff}$ by way of the plasma effect. That is, the wavelength decreases during generation of a 1-bit compared to a 0-bit by about 40 to 80nm, or in other words the optical frequency $v = c / \lambda$ (c=speed of light) increases during 1-bit generation by 5 to 10GHz. This is illustrated schematically in figure 1, which shows amplitude and frequency variation during a "010" modulation at 1Gb/s for a DML showing typical 6GHz adiabatic chirp.

At 1.3μm transmissions (O-band), the effect is less detrimental due to low fibre chromatic dispersion, which is why DMLs are often preferred in this band. Still, transmission distances remain limited to about 20km at 25Gb/s for wavelengths on the edge of the O-band, which is a limitation for 100Gb ethernet based on 4x25Gb/s. At 1.55μm transmissions (C-band), the larger fibres dispersion (~17ps/nm.km) drastically limits transmission to typically 10km at 10Gb/s, and 2km at 25Gb/s.

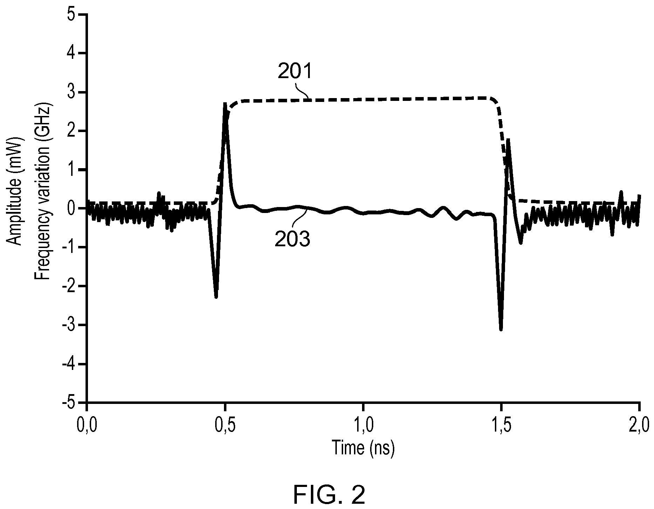

To extend transmission distances Externally Modulated Lasers (EMLs) consisting of a laser section integrated with an electro-absorption modulator can be used. Contrary to DML structures, the laser section of an EML remains at a constant injection current, thereby avoiding any adiabatic chirp, as illustrated Figure 2, which shows amplitude (201) and frequency (203) variation during a "010" modulation at 1Gb/s for an EML (no adiabatic chirp).

However, these devices are more expensive, more power consuming, and provide a lower output power. Besides which, they are not compatible with uncooled operation due to the electro-absorption modulator's strong dependence on temperature.

In order to reduce adiabatic chirp, a DML can be operated with a low extinction ratio of about 3dB for example in order to limit the laser current variations. A filter can be added after the DML, such as for example a ring, or a Fabry-Perot etalon. A filter edge is positioned in order to pass the wavelength of 1-bits and attenuate the wavelength of 0-bits. This Frequency Modulation to Amplitude Modulation (FM-AM) conversion enables an increase in the extinction ratio to a high value (>6dB), while maintaining moderate chirp, reaching distances up to 80km at 10Gb/s for example.

To reach even longer distances, a chirp managed laser (CML), which is based on a DML with a selective filter, but with the additional feature that adiabatic chirp is half the bit rate, i.e. 5GHz for 10Gb/s (100ps-long bits) can be used. In this configuration, phase shift during a 0-bit is $2\pi$ x 5GHz x 100ps = $\pi$. Thus, after propagation, 1-bits interfere destructively with 0-bits. Transmission up to 200km at 10Gb/s has been demonstrated.

However, such systems require the integration of a transmission filter which complicates laser assembly packaging and creates losses. They also impose a requirement for accurate control of detuning between laser and filter, and are not compatible with burst-mode operation of lasers.

According to an example, there is provided a three-section phase-shift DFB laser with two external Bragg sections electrically connected together, and a central phase shift section controllable by an electrode. The phase shift section current $I_{phase}$ controls the position of emission wavelength $I_{emission}$ inside the laser stopband delimited by $\lambda$- and $\lambda$+: when increasing $I_{phase}$, $I_{emission}$ shifts towards $\lambda$-.

In an example, the external Bragg sections electrodes $I_{DFB}$ are directly modulated to generate laser amplitude modulation. Due to adiabatic chirp, the laser stop-band edges $\lambda$- and $\lambda$+ both shift to higher wavelengths during 0-bit generation. By applying a counter-modulation to $I_{phase}$, $I_{emission}$ can be shifted to the left side of the stop-band during 0-bit generation. It is thus possible to maintain a stable wavelength for $I_{emission}$, meaning suppression of the adiabatic chirp.

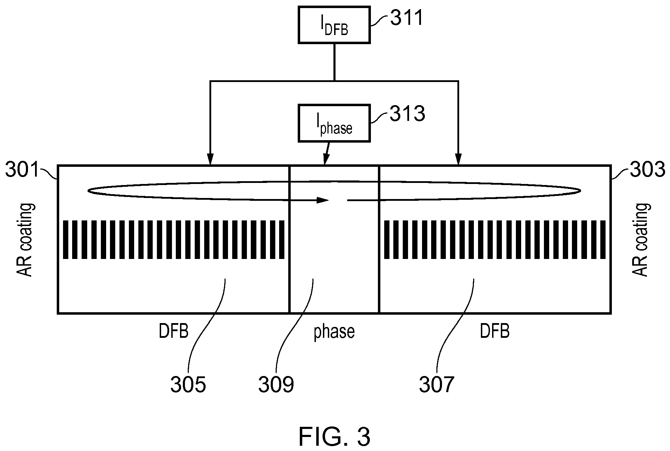

Figure 3 is a schematic representation of a laser apparatus according to an example. The laser apparatus comprises periodically structured active regions 305, 307, and a phase shift region 309 adjacent to the periodically structured active regions.

According to an example, a value of phase current, $I_{phase}$, forming the counter-modulation depends on the length, $L_{phase}$, of the phase section 309. In the example of figure 3, the length of the phase section 309 can be 100μm, which enables sufficient tuning efficiency without increasing the cavity length too much. Phase variation is:

$$2\pi . Dn_{phase}.L_{phase} \, / \, \lambda$$

with $Dn_{phase}$ the phase section index variation due to current injection, $L_{phase}$ the phase section length, and $\lambda$ the wavelength ($\lambda$ = 2.n.pitch_grating). In a $\lambda$/4 laser, the phase shift is a half grating pitch inserted in the middle of the grating: $L_{phase}$ = pitch_grating/2, so the phase shift is $\pi$/2.

For a laser cavity total length of about 500μm (400μm of grating sections + 100μm phase section) the wavelength separation between cavity modes is the free spectral range, FSR = $\lambda^2$/2.ng.$L_{cavity}$ (ng the group index, which is typically around ~3.9 for example), therefore giving:

$$\sim \text{I}\,550^2/(2*3.9*500000) = \sim 0.6\text{nm}.$$

So, a phase shift of $\pi$ would lead to a tuning of 0.6nm.

Supposing, in an example, an adiabatic chirp of 10GHz (which is a pessimistic evaluation), this corresponds to 0.08nm. So, to compensate for this chirp, a phase shift of $\pi$.(0.08)/(0.6) = 0.13.$\pi$ can be used.

This means 2.$\pi$.$Dn_{phase}$.100μm / 1.55μm = 0.13.$\pi$, which means that $Dn_{phase}$ = 0.13 x 1.55μm / (2 x 100μm) = ~0.001.

In tuneable lasers such as DBR lasers, a value of $Dn_{phase}$ = ~0.01nm can be obtained with 40mA over a 100μm-long passive Bragg section (not linear, $Dn_{phase}$ goes with 1^3). So, even if the phase section is optimised for tuning as in a tuneable laser, the current will be around 3mA. If the phase section is only a passive material (such as the modulator stack), 10mA should still be sufficient.

Both (external) facets (301, 303) of the periodically structured active regions 305, 307 are antireflection (AR) coated. In the example of figure 3, the periodically structured active regions 305, 307 are DFB section gratings. These generate a stop-band between $\lambda$- and $\lambda$+, and when injecting current into the DFB sections ($I_{DFB}$) using a first driver 311, the laser apparatus lases at an emission wavelength $\lambda_{emission}$ inside the stop-band of the apparatus. The position of $\lambda_{emission}$ inside the stop-band depends on the phase condition of the central section 309. When injecting current ($I_{phase}$) into the phase section 309 using a second driver 313, the effective index of the phase section 309 decreases thereby changing the phase condition. Accordingly, $\lambda_{emission}$ shifts towards lower wavelengths.

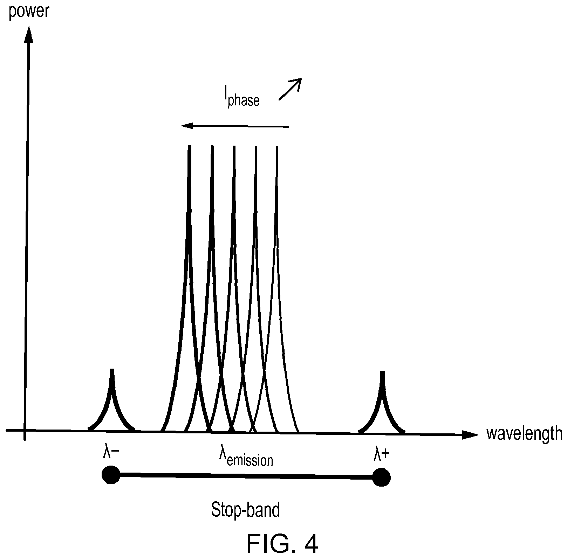

Figure 4 is a schematic representation of a laser spectrum when varying $I_{phase}$ according to an example. As depicted, as the value of $I_{phase}$ is increased, $\lambda_{emission}$ shifts towards lower wavelengths within the stop band (defined between $\lambda$- and $\lambda$+) of the laser apparatus. Thus, since chirp comes from a transition from 0 to 1 or 1 to 0, the effect can be minimised or removed using $I_{phase}$.

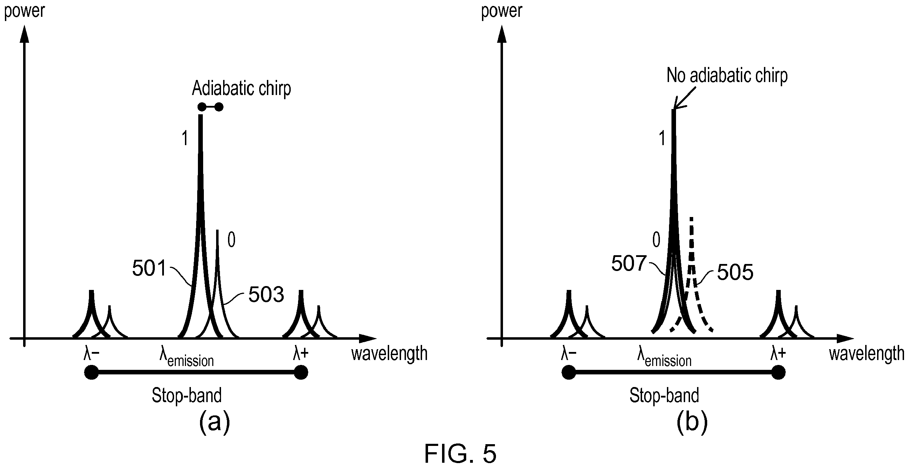

Figure 5 is a schematic representation of a DFB spectrum for 0 and 1 bits according to an example. In figure 5a, when modulating the external Bragg sections current $I_{DFB}$ (see figure 3), the whole emitted spectrum shifts between 0-bits (503) and 1-bits (501) due to adiabatic chirp (due to variations of $n_{eff}$ in the Bragg sections as described above). Referring to figure 5b, if $I_{phase}$ is simultaneously increased during generation of a 0-bit, the central peak 505 shifts towards the left-side of the stop-band, and can remain exactly aligned with 1-bit emission peak 507 by correctly choosing the $I_{phase}$ modulation amplitude. It is therefore possible to totally suppress the adiabatic chirp of the emitted wavelength using a counter-modulation of the phase section.

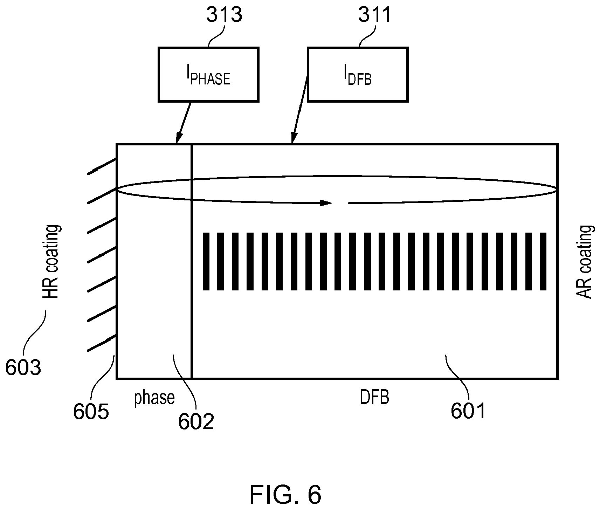

Figure 6 is a schematic representation of a laser apparatus according to an example. In the example of figure 6, the laser cavity of figure 3 is effectively folded on itself to provide one DFB section 601, a phase section 602 and a high-reflection (HR) coating 603 on the back facet 605.

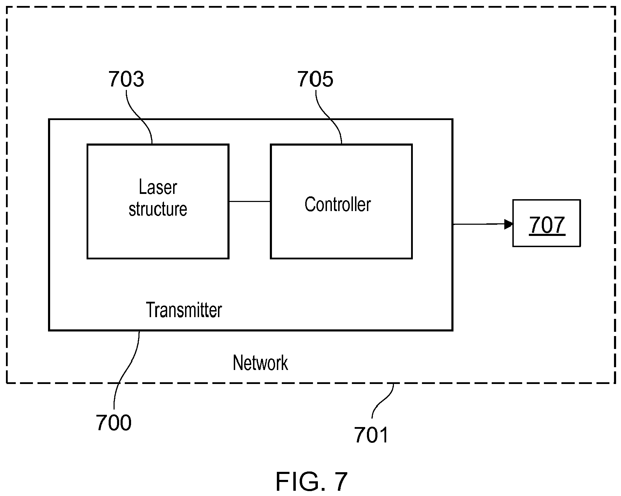

Figure 7 is a schematic representation of a transmitter according to an example. The transmitter 700 of figure 7 is suitable for use in a wireless telecommunications network 701. The transmitter comprises a laser structure 703, and a controller 705. The controller 705 is configured to select a first current for injection into a periodically structured active region of the laser structure 703 to generate an amplitude modulated optical output 707 of the transmitter 700, and select a counter-modulating current for injection into a phase shift region of the laser structure 703 to shift a wavelength of emission of the transmitter to stabilise the wavelength amplitude modulated optical output 707. The selected currents can be supplied (or injected) to the corresponding elements of the laser using appropriate drivers.

The present inventions can be embodied in other specific apparatus and/or methods. The described embodiments are to be considered in all respects as illustrative and not restrictive. In particular, the scope of the invention is indicated by the appended claims rather than by the description and figures herein. All changes that come within the meaning and range of equivalency of the claims are to be embraced within their scope.

**Claims**

1. A laser apparatus comprising:

   a periodically structured active region;
   a phase shift region adjacent to the periodically structured active region;
   a coating adjacent to the periodically structured active region;
   a first driver to inject a current into the periodically structured active region to generate an amplitude modulated optical output; and
   a second driver to inject a counter-modulating current into the phase shift region to shift a wavelength of emission of the laser apparatus.

2. The laser apparatus as claimed in claim 1, wherein the periodically structured active region is a diffraction grating.

3. The laser apparatus as claimed in claim 1 or 2, wherein the coating is an anti-reflective coating.

4. The laser apparatus as claimed in any preceding claim, further comprising a highly reflective coating adjacent the phase shift region.

5. The laser apparatus as claimed in any of claims 1 to 3, further comprising a second periodically structured active region adjacent to the phase shift region; and
   a second coating adjacent to the second periodically structured active region.

6. The laser apparatus as claimed in claim 5, wherein the second coating is an anti-reflective coating.

7. A method for supressing adiabatic chirp in the emission wavelength of a laser apparatus, the method comprising:

   injecting a modulated current into a periodically structured active region of the laser apparatus to drive generation of an amplitude modulated optical output; and
   injecting a counter-modulating current into a phase shift region of the laser apparatus to shift the wavelength of emission of the optical output.

8. The method as claimed in claim 7, further comprising:

determining a level of adiabatic chirp as a result of a shift in laser apparatus stop-band due to a refractive index change stemming from generation of the amplitude modulated optical output; and
selecting the counter-modulating current to supress the said adiabatic chirp by shifting the wavelength of emission of the optical output inside the stop-band.

9. The method as claimed in claim 7 or 8, wherein the adiabatic chirp results from transition of an optical output from or to a 0-bit.

10. The method as claimed in claim 8, further comprising:

   injecting a counter-modulating current into a phase shift region of the laser apparatus to shift the wavelength of emission of the optical output towards the lower limit of the laser apparatus stop-band.

11. The method as claimed in any of claims 7 to 10, wherein the counter-modulating current is selected to reduce the wavelength of emission of the optical output.

12. The method as claimed in any of claims 7 to 11, wherein the counter-modulating current is between 2-20mA.

13. A transmitter for use in a wireless telecommunications network, the transmitter comprising:

   a laser structure; and
   a controller to:

      select a first current for injection into a periodically structured active region of the laser structure to generate an amplitude modulated optical output of the transmitter; and
      select a counter-modulating current for injection into a phase shift region of the laser structure to shift a wavelength of emission of the transmitter to stabilise the wavelength amplitude modulated optical output.

14. The transmitter as claimed in claim 13, wherein the laser structure comprises a coating adjacent to the periodically structured active region.

15. The transmitter as claimed in claim 13 or 14, further comprising:

   a first driver to supply the first current into the periodically structured active region of the laser structure; and

a second driver to supply the counter-modulating current into the phase shift region of the laser structure.

FIG. 1

FIG. 2

FIG. 3

FIG. 4

FIG. 5

EP 3 678 307 A1

FIG. 6

703    705

Laser
structure | Controller | 707

Transmitter

Network

700

701

FIG. 7

Europäisches
Patentamt

European
Patent Office

Office européen
des brevets

## EUROPEAN SEARCH REPORT

Application Number

EP 19 30 5006

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 119 393 A (OKA AKIHIKO [JP] ET AL) 2 June 1992 (1992-06-02) * abstract * * column 9, line 18 - line 46 * * column 10, line 51 - line 57 * * figure 1 * | 1-15 | INV. H04B10/58 H01S5/00 |
| A | US 2013/308178 A1 (MATSUI YASUHIRO [US]) 21 November 2013 (2013-11-21) * paragraph [0040] - paragraph [0043] * | 1-15 | |
| A | US 7 564 889 B2 (FINISAR CORP [US]) 21 July 2009 (2009-07-21) * column 4, line 18 - column 5, line 26 * * figure 2 * | 1-15 | |
| A | US 2004/036943 A1 (FREUND JOSEPH MICHAEL [US] ET AL) 26 February 2004 (2004-02-26) * paragraph [0019] - paragraph [0021] * * paragraph [0025] * * figure 1 * | 1-15 | TECHNICAL FIELDS SEARCHED (IPC) H04B H01S |

The present search report has been drawn up for all claims

| Place of search | Date of completion of the search | Examiner |
|---|---|---|
| Munich | 9 July 2019 | Ribbe, Åsa |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.................................................................

& : member of the same patent family, corresponding
document

EPO FORM 1503 03.82 (P04C01)

**ANNEX TO THE EUROPEAN SEARCH REPORT
ON EUROPEAN PATENT APPLICATION NO.**

EP 19 30 5006

This annex lists the patent family members relating to the patent documents cited in the above-mentioned European search report.
The members are as contained in the European Patent Office EDP file on
The European Patent Office is in no way liable for these particulars which are merely given for the purpose of information.

09-07-2019

| Patent document cited in search report | | Publication date | Patent family member(s) | | Publication date |
|---|---|---|---|---|---|
| US 5119393 | A | 02-06-1992 | CA | 2018928 A1 | 14-12-1990 |
| | | | EP | 0402907 A2 | 19-12-1990 |
| | | | US | 5119393 A | 02-06-1992 |
| US 2013308178 | A1 | 21-11-2013 | CN | 104412148 A | 11-03-2015 |
| | | | CN | 107681461 A | 09-02-2018 |
| | | | US | 2013308178 A1 | 21-11-2013 |
| | | | US | 2013308959 A1 | 21-11-2013 |
| | | | US | 2015280400 A1 | 01-10-2015 |
| | | | WO | 2013173797 A1 | 21-11-2013 |
| US 7564889 | B2 | 21-07-2009 | NONE | | |
| US 2004036943 | A1 | 26-02-2004 | NONE | | |

EPO FORM P0459

For more details about this annex : see Official Journal of the European Patent Office, No. 12/82